Europäisches Patentamt

European Patent Office

Office européen des brevets

(19)

(11) EP 0 903 818 A1

(12) DEMANDE DE BREVET EUROPEEN

(43) Date de publication:
24.03.1999 Bulletin 1999/12

(51) Int Cl.6: **H01S 3/025**, G02F 1/313

(21) Numéro de dépôt: 98402237.6

(22) Date de dépôt: 10.09.1998

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **12.09.1997 FR 9711392**

(71) Demandeur: **FRANCE TELECOM**
**75015 Paris (FR)**

(72) Inventeurs:
• **Loisel, Bertrand**
**22300 Lannion (FR)**
• **Devoldere, Nicole**
**22710 Penvenan (FR)**
• **Bosc, Dominique**
**22300 Lannion (FR)**

(74) Mandataire: **Dubois-Chabert, Guy**
**Société de Protection des Inventions**
**25, rue de Ponthieu**
**75008 Paris (FR)**

(54) **Source optique intégree aiguillable en longueur d'onde et procédé de fabrication**

(57) Source optique intégrée aiguillable en longueur d'onde, procédé de fabrication de celle-ci, application aux modules d'émission-réception et aux systèmes de transmission bidirectionnelle.

Cette source comprend un laser à cavité externe (1) et au moins un coupleur optique symétrique à réseau de Bragg (11) dont une voie d'accès est reliée au laser. Le laser et le coupleur sont formés sur un même substrat (16). De préférence les réseaux de Bragg (10, 14) que comprennent le laser et le coupleur sont inscrits par la méthode du masque de phase.

FIG.4

## Description

## DOMAINE TECHNIQUE

La présente invention concerne une source optique.

Elle s'applique notamment aux télécommunications optiques.

L'invention s'applique plus généralement à tout domaine où la commutation d'un signal optique est nécessaire.

L'invention est plus particulièrement adaptée aux domaines où une longueur d'onde précise doit être commutée entre plusieurs sorties comme cela se fait par exemple pour tester des lignes optiques.

L'invention s'applique aussi à tout domaine où le démultiplexage de longueur d'onde est nécessaire.

L'invention s'applique par exemple aux modules d'émission-réception ainsi qu'aux systèmes de transmission bidirectionnelle.

## ÉTAT DE LA TECHNIQUE ANTÉRIEURE

On connaît déjà un laser à cavité externe par le document suivant auquel on se reportera :

(1) "A Wavelength Stable Uncooled Laser for Access Networks", R.J. Campbell, G. Sherlock, D.L. Williams, R.Payne, R. Wyatt, M. Robertson et J.R. Armitage, Proc. 21st Eur. Conf. On Opt. Comm. ECOC `95, pages 545 à 548.

On connaît également un coupleur symétrique à réseau de Bragg par le document suivant auquel on se reportera :

(2) article de Bakhti F. et al., publié dans Electronics letters, vol.33, n°9, pp.803 et 804, avril 1997.

## EXPOSÉ DE L'INVENTION

La présente invention résout le problème de la conception d'une source optique dont la structure se prête bien à l'aiguillage en longueur d'onde.

Pour résoudre ce problème, la présente invention combine un laser à cavité externe et un coupleur symétrique à réseau de Bragg.

De façon précise, la présente invention a pour objet une source optique comprenant un laser à cavité externe, cette cavité comprenant un premier réseau de Bragg, cette source optique étant caractérisée en ce qu'elle comprend en outre au moins un coupleur optique symétrique à réseau de Bragg comprenant :

-   une partie de couplage comportant un deuxième réseau de Bragg,
-   une première voie d'accès à la partie de couplage,
-   une deuxième voie d'accès à la partie de couplage, qui est située du côté de la première voie d'accès par rapport au deuxième réseau de Bragg et

-   au moins une troisième voie d'accès à la partie de couplage, qui est située du côté opposé à la première voie d'accès par rapport au deuxième réseau de Bragg,

la première voie d'accès étant optiquement couplée au laser à cavité externe,
et en ce que le laser à cavité externe et le coupleur symétrique à réseau de Bragg sont formés sur un même substrat.

Il est alors facile d'aiguiller la lumière émise par le laser soit vers la deuxième voie d'accès soit vers la troisième voie d'accès du coupleur en rendant la longueur d'onde de l'un des deux réseaux de Bragg

-   soit égale à la longueur d'onde de l'autre réseau de Bragg
-   soit différente de cette dernière.

De plus, on obtient ainsi une source optique intégrée capable de fournir une lumière (par la deuxième ou la troisième voie d'accès du coupleur) dont l'intensité est très stable au cours du temps.

En effet, le laser et le coupleur étant formés sur un même substrat, la différence entre la longueur d'onde du premier réseau (faisant partie du laser) et la longueur d'onde du deuxième réseau (faisant partie du coupleur) reste constante au cours du temps.

Cette différence peut même rester nulle au cours du temps lorsque les deux réseaux de Bragg ont la même longueur d'onde.

De préférence, le substrat auquel sont intégrés le laser et le coupleur est en silicium.

Le silicium se prête particulièrement bien à l'intégration du laser à cavité externe, du coupleur symétrique à réseau de Bragg et de guides d'onde optiques destinés à constituer la liaison entre le laser et le coupleur et les voies d'accès de ce coupleur.

Selon un premier mode de réalisation particulier de la source optique objet de l'invention, les premier et deuxième réseaux de Bragg ont la même longueur d'onde.

La source optique peut alors comprendre en outre un moyen de modification de la longueur d'onde de l'un des premier et deuxième réseaux de Bragg pour rendre cette longueur d'onde différente de celle de l'autre des premier et deuxième réseaux de Bragg.

On obtient ainsi un commutateur optique permettant d'aiguiller la lumière émise par le laser à cavité externe

-   soit vers la deuxième voie d'accès du coupleur symétrique à réseau de Bragg lorsque le moyen de modification n'est pas activé et que les premier et deuxième réseaux de Bragg conservent donc la même longueur d'onde
-   soit vers la troisième voie d'accès du coupleur symétrique à réseau de Bragg lorsque le moyen de modification est activé pour rendre les longueurs d'onde des réseaux de Bragg différentes l'une de l'autre.

Selon un deuxième mode de réalisation particulier de la source optique objet de l'invention, les premier et deuxième réseaux de Bragg ont des longueurs d'onde différentes.

On peut alors encore munir cette source optique d'un moyen de modification de la longueur d'onde de l'un des premier et deuxième réseaux de Bragg pour rendre cette longueur d'onde égale à celle de l'autre des premier et deuxième réseaux de Bragg.

On comprendra aisément qu'on obtient ainsi un autre commutateur optique permettant d'aiguiller la lumière émise par le laser à cavité externe soit vers la troisième voie d'accès du coupleur symétrique à réseau de Bragg soit vers la deuxième voie d'accès de celui-ci suivant que le moyen de modification n'est pas activé ou, au contraire, est activé.

Selon un autre mode de réalisation particulier, la source optique objet de l'invention comprend au moins deux coupleurs optiques symériques à réseau de Bragg, chaque coupleur optique symétrique à réseau de Bragg comprenant :

- une partie de couplage comportant un deuxième réseau de Bragg,
- une première voie d'accès à la partie de couplage,
- une deuxième voie d'accès qui est située du côté de la première voie d'accès par rapport au deuxième réseau de Bragg et
- au moins une troisième voie d'accès à la partie de couplage, qui est située du côté opposé à la première voie d'accès par rapport au deuxième réseau de Bragg,

la première voie d'accès et la deuxième voie d'accès de l'un des coupleurs étant respectivement couplées optiquement au laser et à la première voie d'accès de l'autre coupleur, chaque coupleur étant muni d'un moyen de modification de la longueur d'onde du réseau de Bragg que comprend ce coupleur, ce moyen de modification étant apte, lorsqu'il est dans un premier état, à rendre cette longueur d'onde égale à celle du premier réseau de Bragg et, lorsqu'il est dans un deuxième état, à rendre cette longueur d'onde différente de celle du premier réseau de Bragg.

Chaque moyen de modification est par exemple un moyen thermique (qui est dans le premier état lorsqu'il n'est pas chauffé et dans le deuxième état lorsqu'il est chauffé).

La présente invention a également pour objet un module d'émission-réception de lumière, caractérisé en ce qu'il comprend :

- une source optique qui est conforme à la source de l'invention et dans laquelle les premier et deuxième réseaux de Bragg ont la même longueur d'onde et

- un photodétecteur optiquement couplé à la troisième voie d'accès du coupleur et destiné à détecter une lumière dont la longueur d'onde est différente de celle du premier réseau de Bragg et qui est susceptible d'atteindre la deuxième voie d'accès du coupleur.

La présente invention a en outre pour objet un système de transmission bidirectionnelle, caractérisé en ce qu'il comprend :

- deux tels modules d'émission-réception, les longueurs d'onde des premiers réseaux de Bragg appartenant respectivement à ces modules étant différentes l'une de l'autre, et
- une fibre optique qui relie les deuxièmes voies d'accès des coupleurs appartenant respectivement à ces modules.

La présente invention concerne aussi un procédé de fabrication de la source optique objet de l'invention, dans laquelle le laser à cavité externe et le coupleur symétrique à réseau de Bragg sont formés sur un même substrat, de préférence en silicium, et les premier et deuxième réseaux de Bragg sont photo-inscrits par la technique du masque de phase.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- la figure 1 est une vue de dessus schématique d'un laser à cavité externe,
- la figure 2 est une vue de dessus schématique d'un coupleur directif,
- la figure 3 est une vue de dessus schématique d'un coupleur symétrique à réseau de Bragg,
- la figure 4 est une vue de dessus schématique d'une source optique conforme à la présente invention, dans laquelle le réseau de Bragg du laser à cavité externe et le réseau de Bragg du coupleur symétrique à réseau de Bragg ont la même longueur d'onde,
- la figure 5 est une vue de dessus schématique d'une source optique conforme à la présente invention, dans laquelle le réseau de Bragg du laser à cavité externe et le réseau de Bragg du coupleur symétrique à réseau de Bragg ont des longueurs d'onde différentes,
- la figure 6 est une vue en coupe transversale schématique d'un coupleur symétrique à réseau de Bragg utilisable dans l'invention,

- la figure 7 est une vue en coupe transversale schématique d'un sélecteur optique utilisant l'invention,
- la figure 8 est une vue en coupe transversale schématique d'un module d'émission-réception conforme à l'invention,
- la figure 9 est une vue en coupe transversale schématique d'un système de transmission bidirectionnelle conforme à l'invention,
- la figure 10 est une vue en coupe transversale schématique d'un coupleur directif utilisable dans l'invention,
- les figures 11 à 13 illustrent schématiquement des étapes d'un procédé de fabrication du coupleur de la figure 10 et
- la figure 14 illustre schématiquement la formation d'un réseau de Bragg dans le coupleur de la figure 10.

## EXPOSÉ DÉTAILLÉ DE MODES DE RÉALISATION PARTICULIERS

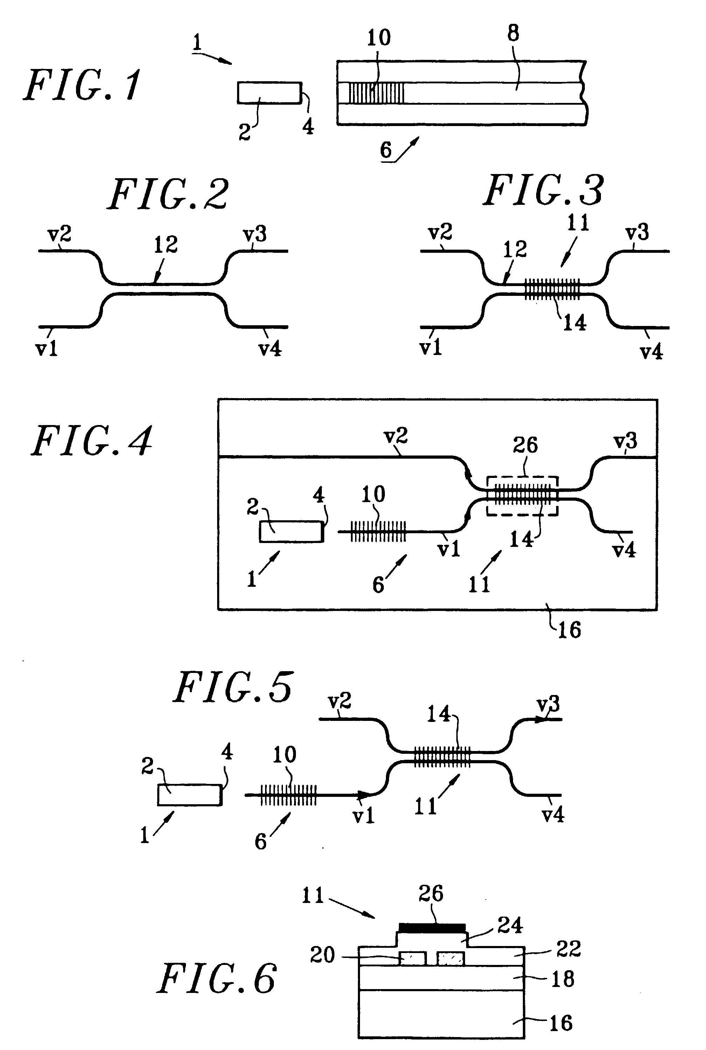

La présente invention utilise un laser à cavité externe dont un exemple est schématiquement représenté sur la figure 1 en vue de dessus.

Le laser à cavité externe 1 de la figure 1 comprend :

- une diode laser 2 dont une face est pourvue d'une couche anti-reflet 4, et
- un guide optique 6 dont une extrémité est située en regard de cette couche 4, à une faible distance de celle-ci.

Le coeur 8 de ce guide optique est muni d'un réseau de Bragg 10 du côté de l'extrémité située en regard de la couche 4.

Un tel laser à cavité externe a pour propriété essentielle d'émettre une lumière dont la longueur d'onde est très précisément définie par la longueur d'onde de réflexion $\lambda$ du réseau de Bragg 10 qui est photo-inscrit dans le coeur 8 du guide.

Cette longueur d'onde $\lambda$ est plus simplement appelée « longueur d'onde du réseau de Bragg ».

Le spectre de réflexion du réseau de Bragg est par exemple centré sur $\lambda$=1550 nanomètres et sa largeur à mi-hauteur vaut par exemple 0,2 nanomètre.

La hauteur de ce spectre peut être ajustée entre 0 (absence du réseau de Bragg) et 1 (réseau de Bragg saturé).

En plaçant la diode laser 2 munie de la couche anti-reflet 4 devant le guide optique 6 muni du réseau de Bragg 10, la longueur d'onde de l'émission laser est centrée sur la longueur d'onde à laquelle le réseau de Bragg réfléchit la lumière, c'est-à-dire 1550 nanomètres dans l'exemple considéré.

On obtient par exemple, pour le spectre d'émission du laser à cavité externe, une largeur à mi-hauteur de 0,05 nanomètre.

Un coupleur optique directif est schématiquement représenté en vue de dessus sur la figure 2 et comprend une zone de couplage ou partie de couplage 12 d'un côté de laquelle on trouve deux voies v1 et v2 d'accès à la zone de couplage du coupleur et, de l'autre côté, deux autres voies v3 et v4 d'accès à cette zone de couplage du coupleur.

Ces voies sont plus simplement appelées « voies d'accès du coupleur ».

Le coupleur de la figure 2 est par exemple conçu de telle manière que des lumières multiplexées de longueurs d'onde respectives $\lambda$B et $\lambda$1 puissent passer de la voie v1 à la voie v3 ou de la voie v2 à la voie v4 (état croisé).

Dans cette configuration, la bande passante optique du coupleur (c'est-à-dire la plage de longueur d'onde où 100% de l'énergie passe d'une voie du coupleur à la voie opposée) est bien évidemment plus grande que l'intervalle de longueurs d'onde [$\lambda$B, $\lambda$1].

Typiquement la bande passante optique d'un tel coupleur peut être supérieure à quelques dizaines de nanomètres alors que la différence entre $\lambda$B et $\lambda$1 peut être aussi faible que 1 nanomètre.

Un coupleur symétrique à réseau de Bragg 11 utilisable dans la présente invention est schématiquement représenté en vue de dessus sur la figure 3.

Le coupleur symétrique à réseau de Bragg de la figure 3 comprend le coupleur directif de la figure 2 et un réseau de Bragg 14 de longueur d'onde $\lambda$B qui est photo-inscrit dans la zone de couplage 12.

Dans ce cas, étant donné les lumières de longueurs d'onde respectives $\lambda$B et $\lambda$1 qui sont injectées dans la voie v1, seule la lumière de longueur d'onde $\lambda$1 passe de la voie v1 à la voie v3.

La lumière de longueur d'onde $\lambda$B est réfléchie vers la voie v2 qui se trouve du même côté que la voie vl par rapport au réseau de Bragg.

Un exemple de source optique conforme à l'invention est schématiquement représenté sur la figure 4 et comprend le laser à cavité externe 1 de la figure 1 et le coupleur symétrique à réseau de Bragg 11 de la figure 3.

Le laser 1 et le coupleur 11 (et donc les réseaux 10 et 14) sont formés sur le même substrat 16 de préférence en silicium.

Dans le cas de la figure 4, la longueur d'onde d'émission du laser à cavité externe 1 (longueur d'onde sur laquelle est centré le spectre de réflexion du réseau de Bragg 10 que comporte ce laser) est égale à la longueur d'onde du réseau de Bragg 14 du coupleur c'est-à-dire la longueur d'onde sur laquelle est centré le spectre de réflexion de ce réseau de Bragg 14.

Ces deux longueurs d'onde identiques sont notées $\lambda$B.

De plus, dans la source optique de la figure 4, l'extrémité du guide optique, qui est opposée à celle où se trouve le réseau de Bragg 10, est reliée à la voie vl du coupleur 11.

La voie v4 n'est pas utilisée dans l'exemple considéré.

Dans le cas de la figure 4, la lumière de longueur d'onde λB émise par le laser à cavité externe 1 est réfléchie vers la voie v2.

Une très faible modification (de l'ordre de 1 nanomètre) de la valeur de la longueur d'onde de réflexion du réseau de Bragg situé dans la zone de couplage du coupleur symérique à réseau de Bragg 11 permet de faire passer la lumière émise par le laser à cavité externe de la voie v1 vers la voie v3.

Lorsque cette longueur d'onde revient à sa valeur λB la lumière ressort de la source optique de la figure 4 par la voie v2.

On obtient ainsi un commutateur optique.

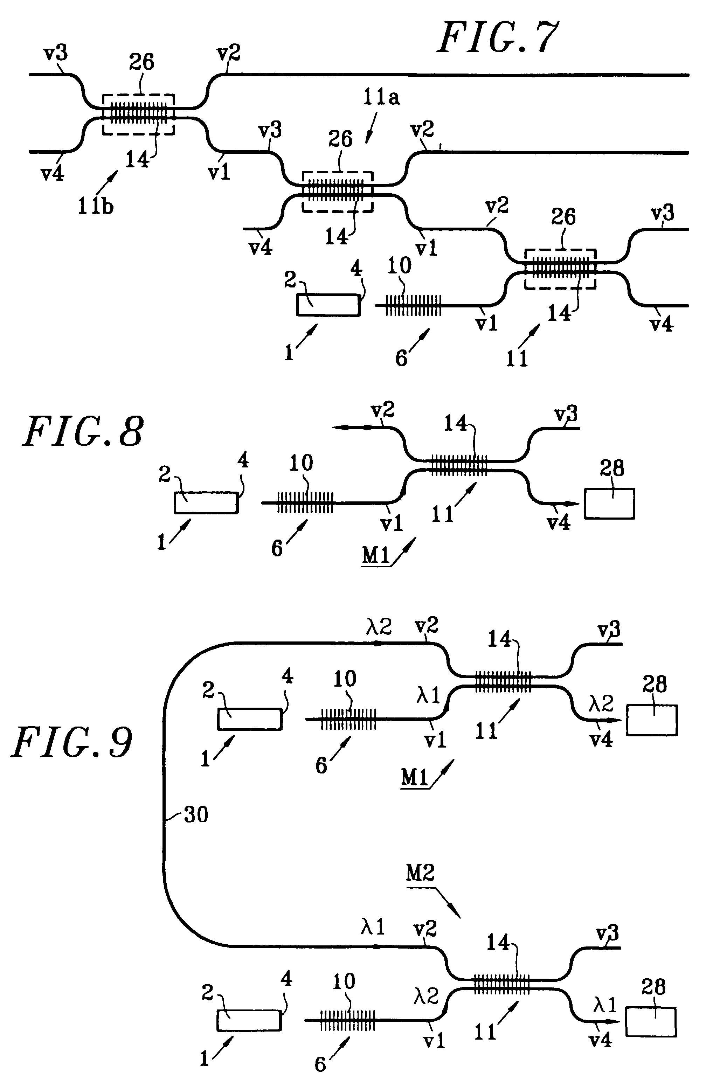

Une autre source optique conforme à l'invention est schématiquement représentée sur la figure 5.

Cette source est encore intégrée sur un substrat (non représenté).

Dans le cas de la figure 5, la longueur d'onde correspondant au réseau de Bragg 14 du coupleur symérique à réseau de Bragg 11 est différente de la longueur d'onde du réseau de Bragg 10 du laser à cavité externe 1.

Cette dernière est alors notée λB tandis que la longueur d'onde associée au réseau de Bragg 14 est notée λBC.

Dans ces conditions, la lumière de longueur d'onde λB, émise par le laser à cavité externe, pénètre dans le coupleur 11 par la voie v1 de celui-ci et ressort du coupleur par la voie v3.

On obtient encore un commutateur optique à partir de la source optique représentée sur la figure 5 si l'on fait varier la longueur d'onde du réseau de Bragg 14 du coupleur 11 pour la rendre égale à celle du laser à cavité externe 1.

Alors, la lumière de longueur d'onde λB sort du coupleur par la voie v2 de celui-ci.

Lorsque la longueur d'onde du réseau de Bragg du coupleur redevient égale à λBC, cette lumière de longueur d'onde λB ressort par la voie v3.

Comme on vient de le voir, la présente invention peut servir à l'obtention d'un commutateur optique.

Le principe d'un tel commutateur repose sur la capacité de modifier la valeur de la longueur d'onde du réseau de Bragg situé dans la zone de couplage du coupleur symérique à réseau de Bragg de la source optique.

Pour modifier cette valeur on peut utiliser un effet thermique.

Si l'on trace les variations de la longueur d'onde d'un réseau photo-inscrit sur un guide en silice en fonction de la température lorsque la température varie d'environ de 20°C à 120°C, cette longueur d'onde de Bragg varie d'environ 1563,4 nanomètres à 1564,6 nanomètres et la courbe des variations est sensiblement rectiligne.

La pente de cette courbe vaut environ 0,013 nanomètre/°C.

Ceci implique qu'une variation de 80°C entraîne un décalage valant environ 1 nanomètre pour la longueur d'onde de Bragg.

Il est à noter qu'un réseau de Bragg photo-inscrit sur un guide optique en silice n'est absolument pas dégradé par des cycles répétés dans une telle gamme de températures.

De plus, ces cycles sont totalement réversibles.

L'effet thermique peut être simplement obtenu par une résistance chauffante déposée sur le coupleur symérique à réseau de Bragg ou par une source de type laser destinée à éclairer ce coupleur.

Ceci est schématiquement illustré par la figure 6 qui est une vue en coupe transversale schématique du coupleur symérique à réseau de Bragg 11 au niveau de la zone de couplage 12 de celui-ci.

Ce coupleur est, comme on l'a vu, formé sur le substrat de silicium 16.

Sur ce substrat 16 est déposée une première couche de silice 18 servant de couche de confinement inférieure au coupleur.

On trouve dans la zone de couplage deux coeurs 20 et 22 en silice convenablement dopée.

Ces coeurs 20 et 22 sont formés sur la couche 18 et sont recouverts par une autre couche de silice 24 servant de couche de confinement supérieure.

Une résistance chauffante 26 est formée sur la couche de confinement supérieure 24.

Cette résistance chauffante est par exemple constituée par une couche métallique qui, lorsqu'une tension est appliquée entre deux extrémités de cette couche métallique, s'échauffe par effet Joule.

Un décalage de 1 nanomètre de la longueur d'onde de Bragg dans le coupleur symérique à réseau de Bragg est largement suffisante pour que le réseau de Bragg du coupleur 11 devienne inopérant vis-à-vis de la longueur d'onde de la lumière émise par le laser à cavité externe 1.

En effet, le pic d'émission de ce laser à cavité externe 1 est par exemple centré sur 1550 nanomètres et a une largeur à mi-hauteur de 0,05 nanomètre.

Le spectre de réflexion du réseau de Bragg 14 du coupleur 11 est par exemple centré sur 1550 nanomètres et a une largeur à mi-hauteur de 0,02 nanomètre.

Lorsque le spectre de réflexion de ce réseau de Bragg du coupleur se retrouve centré sur 1551 nanomètres, avec toujours une largeur à mi-hauteur de 0,02 nanomètre, le pic d'émission du laser se trouve en dehors de ce spectre qui est décalé de 1 nanomètre par rapport au réseau du laser à cavité externe.

La source optique intégrée conforme à l'invention de la figure 4 peut être munie de la résistance chauffante 26 (représentée en pointillés sur la figure 4).

Un autre exemple d'application de l'invention est un sélecteur optique de type 1 vers N où N est un nombre entier au moins égal à 2.

Dans l'exemple schématiquement représenté sur la figure 7, le sélecteur optique correspond à N=4.

Il est intégré sur un substrat (non représenté).

Le sélecteur optique de la figure 7 comprend le laser à cavité externe 1 associé au coupleur symérique à réseau de Bragg 11 et formé sur le même substrat que celui-ci comme on l'a expliqué dans la description de la figure 4.

La longueur d'onde $\lambda$B1 du réseau de Bragg 14 du coupleur 11 est donc égale à la longueur d'onde du réseau de Bragg 10 du laser 1, qui est notée $\lambda$B.

De plus, le sélecteur optique de la figure 7 comprend deux autres coupleurs symériques à réseau de Bragg 11a et 11b qui sont identiques au coupleur symétrique à réseau de Bragg 11 et intégrés sur le même substrat que celui-ci.

Les longueurs d'onde respectives $\lambda$B2 et $\lambda$B3 des réseaux de Bragg 14 des coupleurs 11a et 11b sont donc aussi égales à $\lambda$B.

De plus, le réseau de Bragg 14 de chacun des coupleurs 11, 11a et 11b est muni d'une résistance chauffante 26 permettant de rendre la longueur d'onde de ce réseau de Bragg différente de $\lambda$B.

La voie v2 du coupleur 11 est en outre reliée à la voie v1 du coupleur 11a.

La voie v3 de ce coupleur 11a est reliée à la voie v2 du coupleur 11b.

Le sélecteur optique de la figure 7 comporte quatre sorties respectivement constituées par la voie v3 du coupleur 11, la voie v2 du coupleur 11a et les voies v2 et v3 du coupleur 11b.

La lumière de longueur d'onde $\lambda$B fournie par le laser à cavité externe 1 est disponible sur la voie v3 du coupleur 11 lorsque la longueur d'onde $\lambda$B1 de ce coupleur 11 est rendue différente de $\lambda$B par activation (chauffage) de la résistance 26 correspondante.

Cette lumière est disponible sur la voie v2 du coupleur 11a lorsque $\lambda$B1 est égale à $\lambda$B et que la longueur d'onde $\lambda$B2 du réseau de Bragg du coupleur 11a est aussi égale à $\lambda$B.

Cette lumière est disponible sur la voie v2 du coupleur 11b lorsque $\lambda$B1 est égal à $\lambda$B, que $\lambda$B2 est différent de $\lambda$B et que la longueur d'onde $\lambda$B3 du réseau de Bragg de ce coupleur 11b est égale à $\lambda$B.

Lorsque $\lambda$B1 est égal à $\lambda$B, que $\lambda$B2 est différent de $\lambda$B et que $\lambda$B3 est aussi différent de $\lambda$B alors cette lumière est disponible sur la voie v3 du coupleur 11b.

Un module d'émission-réception conforme à l'invention est schématiquement représenté en vue de dessus sur la figure 8.

Ce module M1 comprend la source optique conforme à l'invention qui est schématiquement représentée sur la figure 4 et qui comprend le laser à cavité externe 1 et le coupleur symétrique à réseau de Bragg 11 (intégrés sur le même substrat).

Dans le cas du module de la figure 8, on note $\lambda$1 la longueur d'onde commune aux réseaux de Bragg appartenant respectivement à ce laser et à ce coupleur.

Le module d'émission-réception M1 de la figure 8 comprend aussi un photodétecteur 28 qui est placé en regard de la voie v4 du coupleur symétrique à réseau de Bragg 11 et qui peut être formé sur le même substrat que celui-ci.

Ce module émet une lumière de longueur d'onde $\lambda$1 par la voie v2.

Une lumière de longueur d'onde $\lambda$2 différente de $\lambda$1, qui arrive à cette voie v2, est détectée par le photodétecteur 28 puisque cette lumière de longueur d'onde $\lambda$2 n'est pas réfléchie par le réseau de Bragg du coupleur 11 et parvient donc à cette voie v4 du coupleur (dans l'état croisé).

La figure 9 est une vue de dessus schématique d'un système de transmission bidirectionnelle ou liaison optique bidirectionnelle de type Full Duplex conforme à l'invention.

Ce système de la figure 9 comprend le module d'émission-réception M1 de la figure 8 qui est destiné à émettre une lumière de longueur d'onde $\lambda$1 et à détecter une lumière de longueur $\lambda$2.

Le système de la figure 9 comprend aussi un autre module d'émission-réception M2 destiné à émettre la lumière de longueur d'onde $\lambda$2 et à détecter la lumière de longueur d'onde $\lambda$1.

Ce module M2 est constitué comme le module M1 mais le réseau de Bragg du laser à cavité externe 1 du module M2 et le réseau de Bragg du coupleur symétrique à réseau de Bragg 11 de ce module M2 ont la même longueur d'onde $\lambda$2.

De plus, comme on le voit sur la figure 9, dans le module M2, la voie v1 du coupleur 11 est reliée au laser à cavité externe 1 de ce module M2, le photodétecteur 28 du module M2 est optiquement couplé à la voie v4 du coupleur 11 et la voie v2 du coupleur 11 est reliée par une fibre optique 30 à la voie v2 du module M1.

Il est à noter que la sélectivité des réseaux de Bragg permet d'associer des sources dont la différence de longueurs d'onde peut être aussi faible que 1 nanomètre.

On explique ci-après un procédé de fabrication de guides optiques photo-inscrits.

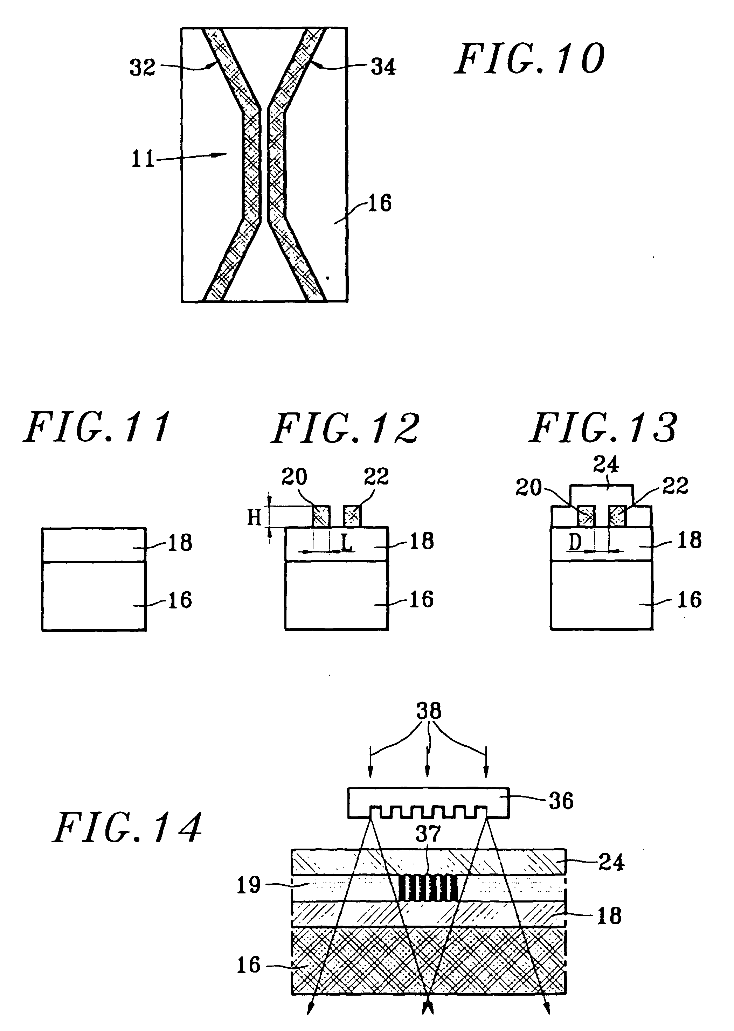

La figure 10 est une vue de dessus schématique du coupleur optique 11.

Ce coupleur est formé sur un substrat de silicium 16.

Ce coupleur comprend deux guides optiques 32 et 34 dont les coeurs sont parallèles l'un à l'autre dans la zone de couplage.

Pour former le coupleur de la figure 10, on commence (figure 11) à déposer une couche de silice 18 sur le substrat 16, cette couche ayant une épaisseur supérieure à 8 µm.

On forme ensuite, par dépôt puis photogravure d'une couche de silice dopée à l'oxyde de germanium, les coeurs respectifs 20 et 22 des guides 32 et 34 comme on le voit sur la figure 12.

Cette couche de silice dopée à l'oxyde de germanium a une épaisseur de 6 μm dans l'exemple considéré.

On recouvre ensuite, comme l'illustre schématiquement la figure 13, les coeurs 20 et 22 des guides ainsi obtenus d'une autre couche de silice 24 dont l'épaisseur est supérieure à 10 μm.

On obtient ainsi le coupleur 11.

Dans l'exemple représenté, chaque coeur a une largeur L de 6 μm et une hauteur H de 6 μm et dans la zone de couplage du coupleur 11 la distance D entre les coeurs 20 et 22 vaut environ 5 μm.

On explique maintenant la photo-inscription du réseau de Bragg dans la zone de couplage du coupleur 11 en faisant référence à la figure 14.

Cette figure 14 est une vue en coupe transversale schématique de l'empilement constitué par le substrat 16, la couche de silice inférieure 18, la couche de silice dopée à l'oxyde de germanium 19 destinée à la formation des coeurs 20 et 22 et la couche de silice supérieure 24.

La photo-inscription est réalisable par diverses techniques mais la technique préférée est la technique du masque de phase.

On utilise dans ce cas un masque de phase 36 qui produit un système d'interférences 37.

Le pas du réseau de diffraction photo-inscrit dans les coeurs des guides du coupleur est égal au pas du masque de phase 36.

Ce pas du réseau de diffraction est donc totalement reproductible, à la reproductibilité près du matériau dont l'indice de réfraction intervient par l'intermédiaire de l'indice effectif Neff des guides.

La longueur d'onde λB du réseau de Bragg ainsi obtenu est donnée par la formule suivante :

$$\lambda B = 2Neff.\Lambda.$$

Dans cette formule, Λ représente le pas du réseau photo-inscrit.

La photo-inscription est par exemple obtenue à l'aide d'un rayonnement ultraviolet 38 de longueur d'onde 244 nanomètres qui est envoyé à travers le masque de phase 36 en direction de l'empilement considéré.

La durée de la photo-inscription peut être comprise entre quelques minutes et plusieurs heures suivant les conditions de préparation de l'empilement.

L'hydrogénation moléculaire sous haute pression (supérieure à $150 \times 10^5$ Pa) réduit considérablement cette durée.

La longueur d'onde de photo-inscription choisie (244 nanomètres) correspond aux bandes d'absorption dues à la présence d'oxyde de germanium dans les coeurs 20 et 22 des guides.

Dans la présente invention on utilise la capacité que l'on a de photo-inscrire, sur un même substrat, plusieurs réseaux de Bragg tant pour les coupleurs que pour les lasers à cavité externe, réseaux dont les longueurs d'onde sont identiques à 0,1 nanomètres près.

Ceci est réalisable en utilisant simultanément deux techniques :

- la réalisation de guides optiques par des techniques micro-électroniques (réalisation de circuits optiques sur un substrat de préférence en silicium)
- la photo-inscription par la technique du masque de phase qui autorise la photo-inscription de plusieurs réseaux de Bragg ayant un pas strictement identique.

On précise que le procédé de formation d'un guide optique unique doté d'un réseau photo-inscrit pour obtenir le laser à cavité externe est semblable à ce que l'on a décrit précédemment.

Comme on l'a vu plus haut la réalisation sur un même substrat en silicium, tel que le substrat 16 des figures 4 et 6, d'un laser à cavité externe et d'un coupleur symétrique à réseau de Bragg couplé à ce laser permet d'obtenir une source monolongueur d'onde commutable en munissant le coupleur d'une résistance chauffante.

Cette réalisation de la source sur un unique substrat de préférence en silicium présente l'avantage suivant.

Lorsque la résistance chauffante n'est pas alimentée ou tout simplement absente alors les deux réseaux de Bragg du laser et du coupleur sont à la même température quelle que soit la valeur de cette température.

Leurs longueurs d'onde associées ont donc strictement la même valeur (ou une différence de valeur constante dans le cas où les deux réseaux ont des longueurs d'onde de Bragg différentes à la température ambiante).

L'invention n'est pas limitée à l'utilisation de coupleurs symériques à réseau de Bragg formés à partir de coupleurs directifs dans l'état croisé.

On peut également utiliser des coupleurs symériques à réseau de Bragg formés à partir de coupleurs directifs dans l'état parallèle ou même de coupleurs directifs quelconques.

De plus, en revenant à la figure 4, on a indiqué qu'il était possible de modifier la longueur d'onde du réseau 14 pour la rendre différente de celle du réseau 10 par exemple au moyen d'une résistance chauffante 26.

Cependant, au lieu de modifier la longueur d'onde du réseau 14 on peut modifier la longueur d'onde du réseau 10.

Pour ce faire on peut former la résistance chauffante 26 non plus au-dessus du réseau 14 mais au-dessus du réseau 10.

On revient sur un exemple de procédé de fabrication d'une source optique conforme à l'invention par exemple du genre de celle de la figure 4 : on forme, sur le même substrat 16, le laser à cavité externe comprenant le premier réseau de Bragg, le coupleur optique symétrique à réseau de Bragg comprenant le deuxième réseau de Bragg, les premier et deuxième réseaux de Bragg ayant la même longueur d'onde, et le moyen de modification de la longueur d'onde de l'un de ces premier et deuxième réseaux de Bragg. De préférence, les premier et deuxième réseaux sont photo-inscrits par la technique du masque de phase et, pour ce faire, les premier et deuxième réseaux sont photo-inscrits à partir d'un même masque comportant deux réseaux de Bragg identiques en des positions correspondant respectivement à celles des premier et deuxième réseaux sur le substrat ou à partir d'un même masque comportant un seul réseau de Bragg et dans ce cas on déplace le substrat devant ce masque pour inscrire successivement les premier et deuxième réseaux sur le substrat.

**Revendications**

1. Source optique comprenant un laser à cavité externe (1), cette cavité comprenant un premier réseau de Bragg (10), cette source optique étant caractérisée en ce qu'elle comprend en outre au moins un coupleur optique symétrique à réseau de Bragg (11, 11a, 11b) comprenant :

   - une partie de couplage comportant un deuxième réseau de Bragg (14),
   - une première voie (v1) d'accès à la partie de couplage,
   - une deuxième voie (v2) d'accès à la partie de couplage, qui est située du côté de la première voie d'accès par rapport au deuxième réseau de Bragg et
   - au moins une troisième voie (v3, v4) d'accès à la partie de couplage, qui est située du côté opposé à la première voie d'accès par rapport au deuxième réseau de Bragg,

   la première voie d'accès (v1) étant optiquement couplée au laser à cavité externe (1),
   et en ce que le laser à cavité externe (1) et le coupleur symérique à réseau de Bragg (11, 11a, 11b) sont formés sur un même substrat (16).

2. Source optique selon la revendication 1, dans laquelle le substrat (16) est en silicium.

3. Source optique selon l'une quelconque des revendications 1 et 2, dans laquelle les premier (10) et deuxième (14) réseaux de Bragg ont la même longueur d'onde.

4. Source optique selon la revendication 3, comprenant en outre un moyen (26) de modification de la longueur d'onde de l'un des premier et deuxième réseaux de Bragg pour rendre cette longueur d'onde différente de celle de l'autre des premier et deuxième réseaux de Bragg.

5. Source optique selon l'une quelconque des revendications 1 et 2, dans laquelle les premier (10) et deuxième (14) réseaux de Bragg ont des longueurs d'onde différentes.

6. Source optique selon la revendication 5, comprenant en outre un moyen de modification de la longueur d'onde de l'un des premier et deuxième réseaux de Bragg pour rendre cette longueur d'onde égale à celle de l'autre des premier et deuxième réseaux de Bragg.

7. Source optique selon la revendication 1, comprenant au moins deux coupleurs optiques symériques à réseau de Bragg (11, 11a, 11b), chaque coupleur optique symétrique à réseau de Bragg comprenant :

   - une partie de couplage comportant un deuxième réseau de Bragg (14),
   - une première voie d'accès à la partie de couplage,
   - une deuxième voie d'accès qui est située du côté de la première voie d'accès par rapport au deuxième réseau de Bragg et
   - au moins une troisième voie d'accès à la partie de couplage, qui est située du côté opposé à la première voie d'accès par rapport au deuxième réseau de Bragg,

   la première voie d'accès et la deuxième voie d'accès de l'un des coupleurs étant respectivement couplées optiquement au laser et à la première voie d'accès de l'autre coupleur, chaque coupleur étant muni d'un moyen (26) de modification de la longueur d'onde du réseau de Bragg que comprend ce coupleur, ce moyen de modification étant apte, lorsqu'il est dans un premier état, à rendre cette longueur d'onde égale à celle du premier réseau de Bragg et, lorsqu'il est dans un deuxième état, à rendre cette longueur d'onde différente de celle du premier réseau de Bragg.

8. Source optique selon l'une quelconque des revendications 4, 6 et 7, dans laquelle le moyen de modification est un moyen thermique (26).

9. Module d'émission-réception de lumière (M1, M2), caractérisé en ce qu'il comprend :

   - une source optique conforme à la revendication 3 et
   - un photodétecteur (28) optiquement couplé à la troisième voie d'accès du coupleur et destiné à détecter une lumière dont la longueur d'onde est différente de celle du premier réseau de Bragg et qui est susceptible d'atteindre la deuxième voie d'accès du coupleur.

10. Système de transmission bidirectionnelle, caractérisé en ce qu'il comprend :

- deux modules d'émission-réception (M1, M2) conformes à la revendication 9, les longueurs d'onde des premiers réseaux de Bragg appartenant respectivement à ces modules étant différentes l'une de l'autre, et
- une fibre optique (30) qui relie les deuxièmes voies d'accès des coupleurs appartenant respectivement à ces modules.

11. Procédé de fabrication de la source optique selon la revendication 4, caractérisé en ce qu'on forme, sur le même substrat (16), le laser à cavité externe comprenant le premier réseau de Bragg, le coupleur optique symétrique à réseau de Bragg comprenant le deuxième réseau de Bragg, les premier et deuxième réseaux de Bragg ayant la même longueur d'onde, et le moyen de modification de la longueur d'onde de l'un de ces premier et deuxième réseaux de Bragg.

12. Procédé selon la revendication 11, dans lequel on photo-inscrit les premier et deuxième réseaux de Bragg par la technique du masque de phase.

13. Procédé selon la revendication 12, dans lequel les premier et deuxième réseaux sont photo-inscrits à partir d'un même masque comportant deux réseaux de Bragg identiques en des positions correspondant respectivement à celles des premier et deuxième réseaux sur le substrat.

14. Procédé selon la revendication 12, dans lequel les premier et deuxième réseaux sont photo-inscrits à partir d'un même masque comportant un seul réseau de Bragg et l'on déplace le substrat devant ce masque pour inscrire successivement les premier et deuxième réseaux sur le substrat.

FIG.1

FIG.2

FIG.3

FIG.4

FIG.5

FIG.6

*FIG.7*

*FIG.8*

*FIG.9*

*FIG.10*

32   34

11   16

*FIG.11*      *FIG.12*      *FIG.13*

18

16

20   22

H

L

18

16

24

20   22

D

18

16

38

36

37

24

19

18

16

*FIG.14*

**Office européen des brevets**

**RAPPORT DE RECHERCHE EUROPEENNE**

Numéro de la demande

EP 98 40 2237

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | EP 0 720 262 A (FRANCE TELECOM) 3 juillet 1996 | 1-5 | H01S3/025 G02F1/313 |
| A | * colonne 7, ligne 48 - colonne 8, ligne 38; figure 4 * | 6,8 | |
| Y | GB 2 170 322 A (PLESSEY CO PLC) 30 juillet 1986 * page 1, colonne de droite, ligne 90-121 * | 1-5 | |
| A | WEBER J -P: "SPECTRAL CHARACTERISTICS BRAGG-REFLECTION TUNABLE OPTICAL FILTER" IEE PROCEEDINGS J. OPTOELECTRONICS, vol. 140, no. 5, PART J, 1 octobre 1993, pages 275-284, XP000412788 * le document en entier * | 1-5,8 | |
| A | EP 0 778 479 A (KOKUSAI DENSHIN DENWA CO LTD) 11 juin 1997 * colonne 4, ligne 41 - colonne 9, ligne 1; figures 5-7 * * colonne 17, ligne 36-43 * | 1-9 | **DOMAINES TECHNIQUES RECHERCHES (Int.Cl.6)** H01S G02F G02B |
| A | ACHATZ V ET AL: "INTEGRATED OPTICAL SWITCHES ON INP FOR NETWORK CONFIGURATION AND DISTRIBUTION" PROCEEDINGS OF THE ELECTRONIC COMPONENTS AND TECHNOLOGY CONFERENCE, ORLANDO, JUNE 1 - 4, 1993, no. CONF. 43, 1 juin 1993, pages 725-728, XP000380071 INSTITUTE OF ELECTRICAL AND ELECTRONICS ENGINEERS * page 726, colonne de gauche; figure 5 * | 1-6 | |

-/--

Le présent rapport a été établi pour toutes les revendications

| Lieu de la recherche | Date d'achèvement de la recherche | Examinateur |
|---|---|---|
| LA HAYE | 27 janvier 1999 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Office européen
des brevets

**RAPPORT DE RECHERCHE EUROPEENNE**

Numéro de la demande

EP 98 40 2237

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | PATENT ABSTRACTS OF JAPAN vol. 013, no. 114 (E-730), 20 mars 1989 & JP 63 287125 A (HITACHI LTD), 24 novembre 1988 * abrégé * | 1,7,9,10 | |
| A | TENNANT D M ET AL: "MULTIWAVELENGHT DISTRIBUTED BRAGG REFLECTOR LASER ARRAY FABRICATED USING NEAR FIELD HOLOGRAPHIC PRINTING WITH AN ELECTRON-BEAM GENERATED PHASE GRATING MASK" JOURNAL OF VACUUM SCIENCE AND TECHNOLOGY: PART B, vol. 11, no. 6, 1 novembre 1993, pages 2509-2513, XP000423405 * le document en entier * | 1,14 | |

**DOMAINES TECHNIQUES RECHERCHES (Int.Cl.6)**

Le présent rapport a été établi pour toutes les revendications

| Lieu de la recherche | Date d'achèvement de la recherche | Examinateur |
|---|---|---|
| LA HAYE | 27 janvier 1999 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

14

**ANNEXE AU RAPPORT DE RECHERCHE EUROPEENNE
RELATIF A LA DEMANDE DE BREVET EUROPEEN NO.**

EP 98 40 2237

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-01-1999

| Document brevet cité au rapport de recherche | | Date de publication | Membre(s) de la famille de brevet(s) | | Date de publication |
|---|---|---|---|---|---|
| EP 0720262 | A | 03-07-1996 | FR<br>JP<br>US | 2728399 A<br>8250819 A<br>5732102 A | 21-06-1996<br>27-09-1996<br>24-03-1998 |
| GB 2170322 | A | 30-07-1986 | AUCUN | | |
| EP 0778479 | A | 11-06-1997 | JP | 9218316 A | 19-08-1997 |

EPO FORM P0460

Pour tout renseignement concernant cette annexe : voir Journal Officiel de l'Office européen des brevets, No.12/82